(19) Europäisches Patentamt
European Patent Office
Office européen des brevets

(11) EP 4 129 676 B1

(12) **EUROPEAN PATENT SPECIFICATION**

(45) Date of publication and mention of the grant of the patent:
**12.02.2025 Bulletin 2025/07**

(21) Application number: **21864466.4**

(22) Date of filing: **06.09.2021**

(51) International Patent Classification (IPC):
***B32B 27/38*** $^{(2006.01)}$ ***C08G 59/50*** $^{(2006.01)}$
***C08L 63/00*** $^{(2006.01)}$ ***B32B 15/092*** $^{(2006.01)}$
***C08K 3/013*** $^{(2018.01)}$ ***H05K 1/05*** $^{(2006.01)}$
***C08G 59/56*** $^{(2006.01)}$

(52) Cooperative Patent Classification (CPC):
(C-Sets available)
**C08K 3/38; B32B 15/092; B32B 15/20; B32B 27/20; B32B 27/38; C08G 59/5033; C08G 59/504; C08G 59/56; C08L 63/00; H05K 1/0373;** B32B 2264/104; B32B 2264/303; B32B 2307/206; B32B 2307/302; B32B 2307/54;
(Cont.)

(86) International application number:
**PCT/JP2021/032726**

(87) International publication number:
**WO 2022/050415 (10.03.2022 Gazette 2022/10)**

(54) **INSULATING RESIN COMPOSITION, INSULATING RESIN CURED BODY, LAYERED BODY, AND CIRCUIT SUBSTRATE**

ISOLIERENDE HARZZUSAMMENSETZUNG, GEHÄRTETER ISOLIERENDER HARZKÖRPER, SCHICHTKÖRPER UND SCHALTUNGSSUBSTRAT

COMPOSITION DE RÉSINE ISOLANTE, CORPS DURCI DE RÉSINE ISOLANTE, CORPS STRATIFIÉ ET SUBSTRAT DE CIRCUIT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.09.2020 JP 2020149727**

(43) Date of publication of application:
**08.02.2023 Bulletin 2023/06**

(73) Proprietor: **Denka Company Limited**
**Tokyo 103-8338 (JP)**

(72) Inventors:
- **GONDA Yuhei**
  **Tokyo 103-8338 (JP)**
- **KUMAGAI Ryota**
  **Tokyo 103-8338 (JP)**

(74) Representative: **Hoffmann Eitle**
**Patent- und Rechtsanwälte PartmbB**
**Arabellastraße 30**
**81925 München (DE)**

(56) References cited:
**WO-A1-2014/136959**
**WO-A1-2018/066277**
**WO-A1-2021/039630**
**CN-A- 102 532 486**
**JP-A- 2014 040 341**
**JP-A- 2017 082 091**
**JP-A- 2017 165 609**
**JP-A- 2018 020 932**
**JP-A- 2018 104 253**
**JP-A- S58 103 526**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 129 676 B1

(52) Cooperative Patent Classification (CPC): (Cont.)
B32B 2307/72; B32B 2457/08; C08K 2003/385; C08K 2201/003; C08K 2201/006; H05K 1/0346; H05K 2201/0209

C-Sets
**C08K 3/38, C08L 63/00;**
**C08L 63/00, C08K 5/18, C08K 5/0091;**
**C08L 63/00, C08K 5/18, C08K 5/55**

## Description

### Technical Field

The present invention relates to an insulating resin composition and a cured body thereof suitably used for manufacturing a circuit substrate (especially a metal base circuit substrate). In addition, the present invention relates to a layered body and a circuit substrate formed using the insulating resin composition.

### Background Art

Various circuit substrates have hitherto been put into practical use as circuit substrates for forming hybrid integrated circuits by mounting electronic/electrical parts such as semiconductor elements. Circuit substrates are classified into resin circuit substrates, ceramic circuit substrates, metal base circuit substrates, and the like based on board materials.

Although resin circuit substrates are inexpensive, these have a low thermal conductivity and therefore are limited to applications requiring relatively low power. Ceramic circuit substrates are suitable for applications requiring relatively high power because of ceramic properties such as high heat resistance and electrical insulation properties, but have a disadvantage of being expensive. On the other hand, metal base circuit substrates have intermediate properties between the two and are suitable for general purpose applications requiring relatively high power, for example, applications such as inverters for refrigerators, inverters for commercial air conditioning, power supplies for industrial robots, and power supplies for automobiles.

For example, Patent Literature 1 discloses a method for obtaining a circuit substrate having excellent stress relaxation properties, heat resistance, moisture resistance, and heat dissipation properties using a circuit substrate composition containing a specific epoxy resin, a curing agent, and an inorganic filler as essential components. JPS58103526A discloses compositions comprising an epoxy resin and a modified aromatic polyamine curing agent.

### Citation List

### Patent Literature

[Patent Literature 1] Japanese Unexamined Patent Publication No. 2008-266533

### Summary of Invention

### Technical Problem

If ceramic circuit substrates can be substituted for metal base circuit substrates, an improvement in productivity can be expected. However, metal base circuit substrates generally tend to have poorer heat dissipation properties than ceramic circuit substrates. In addition, in the fields of industrial modules or the like in which ceramic circuit substrates are used, high voltages may be sometimes applied under severe conditions, and high reliability is required under such conditions.

Therefore, an object of the present invention is to provide an insulating resin composition capable of forming an insulating layer having excellent insulation reliability, high heat cycle resistance, and high thermal conductivity under conditions of high temperature, high humidity, and high-voltage application. In addition, another object of the present invention is to provide a circuit substrate which includes an insulating layer composed of a cured body of the above-described insulating resin composition and has excellent insulation reliability, heat cycle resistance, and heat dissipation properties under conditions of high temperature, high humidity, and high-voltage application.

### Solution to Problem

The present invention includes aspects shown below.

(1) An insulating resin composition including: an epoxy resin; an amine-based curing agent containing a first amine compound represented by Formula (A-1) and a second amine compound represented by Formula (A-2), wherein, in the amine-based curing agent, a ratio ($M_2/M_1$) of a total number $M_2$ of $-NHR^1$'s to a total number $M^1$ of $-NH^2$'s is 0.05 to 0.30; and an inorganic filler having a thermal conductivity of 20 W/mK or higher, in which a content of the inorganic filler is 30 to 80 volume%; wherein the content of components other than the epoxy resin, the amine-based curing agent and the inorganic filler is 2 mass% or less based on the total amount of the insulating resin composition.

[Chem. 1]

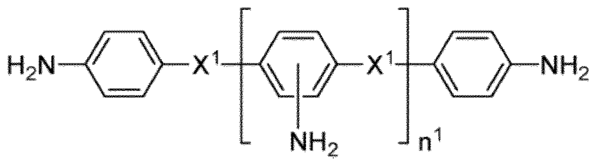

(A-1)

[In Formula (A-1), $n^1$ represents an integer of 0 to 4, and $X^1$ represents an alkanediyl group, an oxygen atom, or a sulfur atom; and when $n^1$ is 1 or more, plural $X^1$'s may be the same as or different from each other].

[Chem. 2]

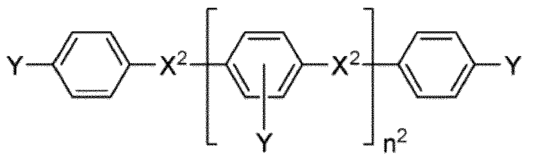

(A-2)

[In Formula (A-2), $n^2$ represents an integer of 0 to 4, $X^2$ represents an alkanediyl group, an oxygen atom, or a sulfur atom, and Y represents a group represented by $-NH_2$ or $-NHR^1$ ($R^1$ represents a group represented by Formula (Y-1)); plural Y's may be the same as or different from each other, provided that at least one of Y's is $-NHR^1$; and when $n^2$ is 1 or more, plural $X^2$'s may be the same as or different from each other].

[Chem. 3]

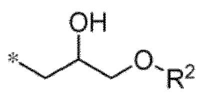

(Y-1)

[In Formula (Y-1), $R^2$ represents an alkyl group].

(2) The insulating resin composition according to (1), in which the inorganic filler contains an agglomerated powder containing an aggregate of primary particles.

(3) The insulating resin composition according to (2), in which the agglomerated powder has an average particle diameter of 20 to 100 μm.

(4) The insulating resin composition according to (2) or (3), in which the agglomerated powder has a crushing strength of 1 to 30 MPa.

(5) The insulating resin composition according to any one of (2) to (4), in which the agglomerated powder has a tap density of 0.7 to 2.0 $g/cm^3$.

(6) The insulating resin composition according to any one of (2) to (5), in which the agglomerated powder has a specific surface area of 3.0 to 10.0 $m^2/g$.

(7) The insulating resin composition according to any one of (2) to (6), in which the agglomerated powder contains boron nitride.

(8) The insulating resin composition according to any one of (1) to (7), in which the $X^1$ and the $X^2$ are methanediyl groups.

(9) The insulating resin composition according to any one of (1) to (8), in which, in the amine-based curing agent, a content of the first amine compound is 30 to 60 mass% and a content of the second amine compound is 40 to 70 mass%.

(10) The insulating resin composition according to any one of (1) to (10), in which a ratio of an active hydrogen equivalent of the amine-based curing agent to an epoxy equivalent of the epoxy resin is 0.3 to 1.5.

(11) An insulating resin cured body which is a cured body of the insulating resin composition according to any one of (1) to (10).

(12) The insulating resin cured body according to (11), including: a crushed material of the inorganic filler.

(13) The insulating resin cured body according to (11) or (12), in which a cross-linking density is $4.0\times10^{-2}$ $5.0\times10^{-1}$ $mol/cm^3$.

(14) The insulating resin cured body according to any one of (11) to (13), in which a storage elastic modulus at -40°C is

100 GPa or less.

(15) A method for producing an insulating resin cured body, the method including: a step of curing the insulating resin composition according to any one of (1) to (10) or a semi-cured body thereof through heat pressing to produce an insulating resin cured body.

(16) A layered body including: a metal plate; the insulating resin cured body according to any one of (11) to (14) placed on the metal plate; and a metal foil placed on the insulating resin cured body.

(17) A circuit substrate including: a metal plate; the insulating resin cured body according to any one of (11) to (14) placed on the metal plate; and a circuit part placed on the insulating resin cured body.

**Advantageous Effects of Invention**

According to the present invention, there is provided an insulating resin composition capable of forming an insulating layer having excellent insulation reliability, high heat cycle resistance, and high thermal conductivity under conditions of high temperature, high humidity, and high-voltage application. In addition, according to the present invention, there is also provided a circuit substrate which includes an insulating layer composed of a cured body of the above-described insulating resin composition and has excellent insulation reliability, heat cycle resistance, and heat dissipation properties under conditions of high temperature, high humidity, and high-voltage application.

**Brief Description of Drawings**

FIG. 1 is a cross-sectional view illustrating an embodiment of a layered body.
FIG. 2 is a cross-sectional view illustrating an embodiment of a circuit substrate.

**Description of Embodiments**

Hereinafter, suitable embodiments of the present invention will be described in detail.

(Insulating Resin Composition)

The insulating resin composition of the present embodiment contains an epoxy resin, an amine-based curing agent, and an inorganic filler having a thermal conductivity of 20 W/mK or higher. In the present embodiment, the amine-based curing agent contains a first amine compound represented by Formula (A-1) and a second amine compound represented by Formula (A-2) , wherein, in the amine-based curing agent, a ratio ($M_2/M_1$) of a total number $M_2$ of $-NHR^1$'s to a total number $M^1$ of $-NH^2$'s is 0.05 to 0.30. In addition, in the present embodiment, the content of the inorganic filler is 30 to 80 volume%, and the content of components other than the epoxy resin, the amine-based curing agent and the inorganic filler is 2 mass% or less based on the total amount of the insulating resin composition.

[Chem. 4]

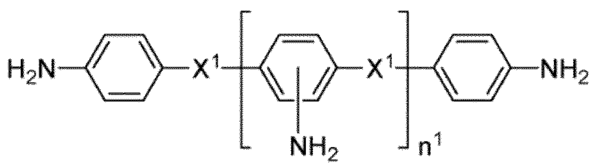

(A-1)

In Formula (A-1), $n^1$ represents an integer of 0 to 4, and $X^1$ represents an alkanediyl group, an oxygen atom, or a sulfur atom. When $n^1$ is 1 or more, plural $X^1$'s may be the same as or different from each other.

[Chem. 5]

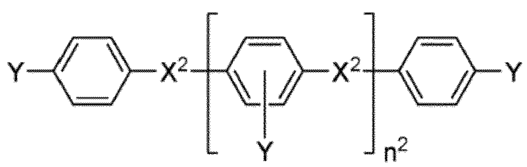

(A-2)

In Formula (A-2), $n^2$ represents an integer of 0 to 4, $X^2$ represents an alkanediyl group, an oxygen atom, or a sulfur atom, and Y represents a group represented by $-NH_2$ or $-NHR^1$ ($R^1$ represents a group represented by Formula (Y-1)). Plural Y's may be the same as or different from each other. However, at least one of Y's is $-NHR^1$. when $n^2$ is 1 or more, plural $X^2$'s may be the same as or different from each other.

[Chem. 6]

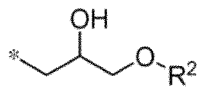 (Y-1)

In Formula (Y-1), $R^2$ represents an alkyl group.

The insulating resin composition of the present embodiment can form an insulating resin cured body capable of maintaining excellent insulation reliability (for example, 200 hours or longer) even under conditions of high temperature and high humidity (for example, 85°C and 85 %RH) and high-voltage application (for example, DC 1200 V) by combining the above-described amine-based curing agent with the epoxy resin. For this reason, according to the insulating resin composition, a circuit substrate having excellent insulation reliability and heat cycle resistance under conditions of high temperature, high humidity, and high-voltage application can be manufactured.

Although the reason why the above-described effects are obtained is not necessarily clear, it is thought that this is because the use of the second amine compound reduces the cross-linking density of a cured body and introduces alkyl groups, resulting in improved flexibility of the cured product and formation of an insulating layer having excellent heat cycle characteristics.

In addition, since the insulating resin composition of the present embodiment has the above-described inorganic filler mixed thereinto, an insulating resin cured body with a high thermal conductivity can be formed. For this reason, according to the insulating resin composition of the present embodiment, a circuit substrate with excellent heat dissipation properties can be manufactured. In the present embodiment, by mixing in a predetermined amount of inorganic filler with a predetermined thermal conductivity, it is possible to realize a high thermal conductivity while obtaining sufficient effects of the above-described insulation reliability and heat cycle resistance.

Any epoxy resin may be used as long as it can be cured by amine-based curing agents. Examples of epoxy resins include a bisphenol A-type epoxy resin, a bisphenol S-type epoxy resin, a bisphenol F-type epoxy resin, a hydrogenated bisphenol A-type epoxy resin, a polypropylene glycol-type epoxy resin, a polytetramethylene glycol-type epoxy resin, a naphthalene-type epoxy resin, a phenylmethane-type epoxy resin, a tetrakisphenolmethane-type epoxy resin, a biphenyl-type epoxy resin, an epoxy resin having a triazine ring, a bisphenol A-alkylene oxide adduct-type epoxy resin, a dicyclopentadiene-type epoxy resin, a cresol novolac-type epoxy resin, and a phenol novolac-type epoxy resin. Epoxy resins may be used alone or in a combination of two or more thereof.

From the viewpoint of heat resistance, an epoxy resin preferably has at least one ring structure selected from the group consisting of a benzene ring structure, a naphthalene ring structure, and a triazine ring structure.

The amine-based curing agent is a curing agent which has an amino group and is capable of curing an epoxy resin. In the present embodiment, the amine-based curing agent contains a first amine compound represented by Formula (A-1) and a second amine compound represented by Formula (A-2).

In Formula (A-1), $n^1$ is 0 to 4, preferably 0 to 2, and more preferably 0 or 1.

In Formula (A-1), $X^1$ is an alkanediyl group, an oxygen atom, or a sulfur atom and preferably an alkanediyl group. The number of carbon atoms in an alkanediyl group is preferably 1 to 5, more preferably 1 to 3, and still more preferably 1 (that is, a methanediyl group).

Plural $X^1$'s may be the same as or different from each other and are preferably the same as each other.

In Formula (A-2), $n^2$ is 0 to 4, preferably 0 to 2, and more preferably 0 or 1.

In Formula (A-2), $X^2$ is an alkanediyl group, an oxygen atom, or a sulfur atom and preferably an alkanediyl group. The number of carbon atoms in an alkanediyl group is preferably 1 to 5, more preferably 1 to 3, and still more preferably 1 (that is, a methanediyl group).

Plural $X^2$'s may be the same as or different from each other and are preferably the same as each other.

$X^2$ may be the same group as $X^1$. Such an aspect facilitates the production of the amine-based curing agent.

In Formula (A-2), Y is $-NH^2$ or $-NHR^1$. Plural Y's may be the same as or different from each other, and at least one of Y's is $-NHR^1$.

In a preferred aspect, an amine-based curing agent may contain an amine compound (A-2-1) in which some Y's are $-NH^2$ and others are $-NHR^1$ and an amine compound (A-2-2) in which all Y's are $-NHR^1$.

In Formula (A-2), $R^1$ is a group represented by Formula (Y-1). In Formula (Y-1), $R^2$ is an alkyl group, preferably an alkyl group having 1 to 8 carbon atoms, and more preferably an alkyl group having 3 to 5 carbon atoms. An alkyl group for $R^2$ may be linear, branched, or cyclic, and is preferably linear from the viewpoint of further improving flexibility of a cured

body.

The ratio ($M_2/M_1$) of a total number $M_2$ of -NHR$^{1}$'s to a total number $M^1$ of -NH$^{2}$'s is 0.05 or more, preferably 0.08 or more, and more preferably 0.10 or more. Accordingly, a cured body with superior insulation reliability under conditions of high temperature, high humidity, and high-voltage application is obtained. In addition, the above-described ratio ($M_2/M_1$) is 0.30 or less, preferably 0.25 or less, and still more preferably 0.20 or less. Accordingly, the insulation properties of a cured body tend to be further improved. That is, the above-described ratio ($M_2/M_1$) is 0.05 to 0.30, and may be, for example,0.05 to 0.25, 0.05 to 0.20, 0.08 to 0.30, 0.08 to 0.25, 0.08 to 0.20, 0.10 to 0.30, 0.10 to 0.25, or 0.10 to 0.20.

From the viewpoint of further improving the insulation properties of a cured body, the content of the first amine compound in the amine-based curing agent may be, for example, 15 mass% or more, preferably 30 mass% or more, and more preferably 40 mass% or more. In addition, from the viewpoint of obtaining a cured body with superior insulation reliability under conditions of high temperature, high humidity, and high-voltage application, the content of the first amine compound in the amine-based curing agent may be, for example, 75 mass% or less, preferably 60 mass% or less, and more preferably 55 mass% or less. That is, the content of the first amine compound in the amine-based curing agent may be, for example, 15 to 75 mass%, 15 to 60 mass%, 15 to 55 mass%, 30 to 75 mass%, 30 to 60 mass%, 30 to 55 mass%, 40 to 75 mass%, 40 to 60 mass%, or 40 to 55 mass%.

From the viewpoint of obtaining a cured body with superior insulation reliability under conditions of high temperature, high humidity, and high-voltage application, the content of the second amine compound in the amine-based curing agent may be, for example, 30 mass% or more, preferably 40 mass% or more, and more preferably 45 mass% or more. In addition, from the viewpoint of further improving the insulation properties of a cured body, the content of the second amine compound in the amine-based curing agent may be, for example, 80 mass% or less, preferably 70 mass% or less, and more preferably 55 mass% or less. That is, the content of the second amine compound in the amine-based curing agent may be, for example, 30 to 80 mass%, 30 to 70 mass%, 30 to 55 mass%, 40 to 80 mass%, 40 to 70 mass%, 40 to 55 mass%, 45 to 80 mass%, 45 to 70 mass%, or 45 to 55 mass%.

The amine-based curing agent may further contain an amine-based curing agent other than the first amine compound and the second amine compound, but preferably contains the first amine compound and the second amine compound as main components. Specifically, the total content of the first amine compound and the second amine compound in the amine-based curing agent is, for example, 50 mass% or more, preferably 70 mass% or more, more preferably 90 mass% or more, and more preferably 95 mass%, and may be 95 mass% or more, 99 mass% or more, and 100 mass%.

Examples of amine-based curing agents other than the first amine compound and the second amine compound include ethylenediamine, diethylenetriamine, hexamethylenediamine, meta-phenylenediamine, diaminodiphenyl sulfone, pentaethylenediamine, and diethylene glycol bispropylamine.

From the viewpoint of obtaining a cured body with superior insulation reliability under conditions of high temperature, high humidity, and high-voltage application, the content of the amine-based curing agent is preferably such that the ratio of the active hydrogen equivalent of the amine-based curing agent to the epoxy equivalent of the epoxy resin is within the following range. The ratio of the active hydrogen equivalent of the amine-based curing agent to the epoxy equivalent of the epoxy resin may be, for example, 0.2 or more, preferably 0.3 or more, and more preferably 0.5 or more. In addition, the ratio of the active hydrogen equivalent of the amine-based curing agent to the epoxy equivalent of the epoxy resin may be, for example, 1.8 or less, preferably 1.5 or less, and more preferably 1.2 or less. That is, the ratio of the active hydrogen equivalent of the amine-based curing agent to the epoxy equivalent of the epoxy resin may be, for example, 0.2 to 1.8, 0.2 to 1.5, 0.2 to 1.2, 0.3 to 1.8, 0.3 to 1.5, 0.3 to 1.2, 0.5 to 1.8, 0.5 to 1.5, or 0.5 to 1.2.

The insulating resin composition of the present embodiment can also be said to be a composition containing a resin component containing an epoxy resin and an amine-based curing agent, and an inorganic filler.

The total content of the epoxy resin and the amine-based curing agent in the resin component may be, for example, 80 mass% or more, preferably 85 mass% or more, more preferably 90 mass% or more, and still more preferably 95 mass% or more, based on the total amount of the resin component.

The thermal conductivity of the inorganic filler is 20 W/mK or higher, preferably 50 W/mK or higher, and more preferably 100 W/mK or higher. Accordingly, a cured body with a higher thermal conductivity is likely to be obtained. In addition, the upper limit of the thermal conductivity of the inorganic filler is not particularly limited but may be, for example, 3500 W/mK or lower, 2000 W/mK or lower, or 600 W/mK or lower. Accordingly, the cost for producing a resin composition can be reduced. That is, the conductivity of the inorganic filler may be, for example, 20 to 3500 W/mK, 20 to 2000 W/mK, 20 to 600 W/mK, 50 to 3500 W/mK, 50 to 2000 W/mK, 50 to 600 W/mK, 100 to 3500 W/mK, 100 to 2000 W/mK, or 100 to 600 W/mK.

The inorganic filler can be said to be a filler composed of an inorganic material. Any inorganic material may be used as long as the above-described thermal conductivity can be achieved. Examples of inorganic materials include boron nitride, aluminum oxide, magnesium oxide, aluminum nitride, and silicon nitride.

Agglomerated powders containing aggregates of primary particles can be suitably used as the inorganic filler. When the inorganic filler contains agglomerated powders, at least some agglomerated powders are deformed or crushed

by pressure applied during curing of an insulating resin composition, the contact points between inorganic filler particles (between the agglomerated powders) increase, and the thermal conductivity tends to be further improved.

The average particle diameter of the agglomerated powders may be, for example, 10 μm or more, preferably 20 μm or more, more preferably 25 μm or more, and still more preferably 30 μm or more. Accordingly, the contact surface between the agglomerated powders and the resin component decreases, and the thermal conductivity tends to be further improved. In addition, the average particle diameter of the agglomerated powders may be, for example, 150 μm or less, preferably 100 μm or less, more preferably 90 μm or less, and still more preferably 80 μm or less. Accordingly, the filling properties with respect to the resin are further improved, the filling rate is likely to be increased, and a cured body with a higher thermal conductivity is likely to be obtained. That is, the average particle diameter of the agglomerated powders may be, for example, 10 to 150 μm, 10 to 100 μm, 10 to 90 μm, 10 to 80 μm, 20 to 150 μm, 20 to 100 μm, 20 to 90 μm, 20 to 80 μm, 25 to 150 μm, 25 to 100 μm, 25 to 90 μm, 25 to 80 μm, 30 to 150 μm, 30 to 100 μm, 30 to 90 μm, or 30 to 80 μm.

In the present specification, the average particle diameter of the agglomerated powders indicates a cumulative 50% particle diameter of cumulative particle size distribution which is measured by measuring particle size distribution through a laser diffraction scattering method according to JIS Z8825.

The crushing strength of the agglomerated powders may be, for example, 0.5 MPa or more, preferably 1 MPa or more, and more preferably 1.5 MPa or more. Accordingly, the breakage of the agglomerated powders before curing (for example, when producing an insulating resin composition or when producing a semi-cured body of an insulating resin composition) is suppressed, and the above-described effects are more significantly exhibited. In addition, the crushing strength of the agglomerated powders may be, for example, 40 MPa or less, preferably 30 MPa or less, and more preferably 20 MPa or less. Accordingly, the agglomerated powders during curing of an insulating resin composition are likely to be deformed or crushed, and the above-described curing is more significantly exhibited. That is, the crushing strength of the agglomerated powders may be, for example, 0.5 to 40 MPa, 0.5 to 30 MPa, 0.5 to 20 MPa, 1 to 40 MPa, 1 to 30 MPa, 1 to 20 MPa, 1.5 to 40 MPa, 1.5 to 30 MPa, or 1.5 to 20 MPa.

In the present specification, the crushing strength of the agglomerated powders means a value which is obtained from a test force during deformation of particles and measured according to JIS R 1639-5. More specifically, a test force can be measured with, for example, a microcompression tester "MCT-510" (manufactured by Shimadzu Corporation, trade name), and the crushing strength can be calculated based on the following equation.

$$S_t=AP/\pi d^2$$

In the formula, St is a crushing strength (MPa), A is a coefficient, P is a breaking test force (N), and d is a particle diameter (mm). The coefficient A in the equation is determined according to components constituting the agglomerated powders. For example, in a case of boron nitride agglomerated powders, the coefficient is determined as "2.8" with reference to Journal of the Mining and Metallurgical Institute of Japan, 81, p. 1024, 1965.

The test is performed by a compression test using a φ200 μm flat indenter under test conditions of a set test force of 49 (mN) and a loading rate of 0.25 (mN/sec). The measurement was performed 10 times, and an average value of crushing strength calculated for each measurement is taken as crushing strength of the agglomerated powders.

The tap density of the agglomerated powders may be, for example, 0.4 g/cm$^3$ or more, preferably 0.6 g/cm$^3$ or more, and more preferably 0.7 g/cm$^3$ or more. Accordingly, the coatability of the resin composition and the insulation properties of a cured body tend to be further improved. In addition, the tap density of the agglomerated powders may be, for example, 3.0 g/cm$^3$ or less, preferably 2.0 g/cm$^3$ or less, and more preferably 1.0 g/cm$^3$ or less. Accordingly, the above-described suitable crushing strength is likely to be obtained, and the thermal conductivity of a cured body tends to be further improved. That is, the tap density of the agglomerated powders may be, for example, 0.4 to 3.0 g/cm$^3$, 0.4 to 2.0 g/cm$^3$, 0.4 to 1.0 g/cm$^3$, 0.6 to 3.0 g/cm$^3$,, 0.6 to 2.0 g/cm$^3$, 0.6 to 1.0 g/cm$^3$, 0.7 to 0.3 g/cm$^3$, 0.7 to 0.2 g/cm$^3$, or 0.7 to 1.0 g/cm$^3$.

In the present specification, the tap density of the agglomerated powders can be measured using a commercially available device according to JIS R1628. Specifically, the bulk density after filling a 100 cm$^3$ dedicated container with agglomerated powders and performing tapping under the conditions of a tapping time of 180 seconds, the number of times of tapping of 180 times, and the tap lift of 18 mm is measured and taken as tap density.

The specific surface area of the agglomerated powders may be, for example, 1.5 m$^2$/g or more, preferably 2.0 m$^2$/g or more, more preferably 2.5 m$^2$/g or more, still more preferably 3.0 m$^2$/g or more, and still more preferably 3.5 m$^2$/g or more. Accordingly, the contact area between the agglomerated powders in the insulating resin composition increases, and the thermal conductivity is likely to be further improved. In addition, the specific surface area of the agglomerated powders may be, for example, 12.0 m$^2$/g or less, preferably 10.0 m$^2$/g or less, more preferably 8.0 m$^2$/g or less, and still more preferably 6.0 m$^2$/g or less. Accordingly, the coatability of the insulating resin composition and the insulation properties of a cured body tend to be further improved. That is, the specific surface area of the agglomerated powders may be, for example, 1.5 to 12.0 m$^2$/g, 1.5 to 10.0 m$^2$/g, 1.5 to 8.0 m$^2$/g, 1.5 to 6.0 m$^2$/g, 2.0 to 12.0 m$^2$/g, 2.0 to 10.0 m$^2$/g, 2.0 to 8.0 m$^2$/g, 2.0 to 6.0 m$^2$/g, 2.5 to 12.0 m$^2$/g, 2.5 to 10.0 m$^2$/g, 2.5 to 8.0 m$^2$/g, 2.5 to 6.0 m$^2$/g, 3.0 to 12.0 m$^2$/g, 3.0 to 10.0 m$^2$/g,

3.0 to 8.0 $m^2/g$, 3.0 to 6.0 $m^2/g$, 3.5 to 12.0 $m^2/g$, 3.5 to 10.0 $m^2/g$, 3.5 to 8.0 $m^2/g$, or 3.5 to 6.0 $m^2/g$.

In the present specification, the specific surface area of the agglomerated powders indicates a value calculated by applying a BET 1-point method as a method of calculating the specific surface area using a generally commercially available measurement device utilizing a gas adsorption phenomenon.

As the agglomerated powders, agglomerated powders containing boron nitride are preferable, and agglomerated powders composed of boron nitride (agglomerated boron nitride powders) are more preferable. The agglomerated boron nitride powders may be, for example, aggregates obtained such that flaky boron nitride primary particles are aggregated into a spherical shape.

In the present embodiment, agglomerated powders and a filler other than the agglomerated powders may be used in combination as an inorganic filler. The proportion of the agglomerated powders in the inorganic filler may be, for example, 30 volume% or more, preferably 50 volume% or more, more preferably 70 volume% or more, and still more preferably 90 volume% or more, and may be 95 volume% or more or may be 100 volume% (that is, no filler other than the agglomerated powders is contained).

The content of the inorganic filler in the insulating resin composition is, based on the total amount of the insulating resin composition, 30 volume% or more, preferably 35 volume% or more, and more preferably 40 volume% or more. Accordingly, the thermal conductivity of a cured body tends to be further improved. In addition, the content of the inorganic filler in the insulating resin composition is, based on the total amount of the insulating resin composition, 80 volume% or less, preferably 75 volume% or less, and more preferably 70 volume% or less. Accordingly, the coatability of the insulating resin composition is further improved, and a cured body having excellent insulation properties is more likely to be obtained. That is, the content of the inorganic filler in the insulating resin composition may be, based on the total amount of the insulating resin composition, for example, 30 to 80 volume%, 30 to 75 volume%, 30 to 70 volume%, 35 to 80 volume%, 35 to 75 volume%, 35 to 70 volume%, 40 to 80 volume%, 40 to 75 volume%, or 40 to 70 volume%.

In addition, the inorganic filler may be mixed in the insulating resin composition so that the content thereof in the insulating resin cured body is within a predetermined range. The content of the inorganic filler in the insulating resin cured body is, from the viewpoint of further improving a thermal conductivity, preferably 30 volume% or higher, more preferably 35 volume% or higher, and still more preferably 40 volume% or higher. In addition, the content of the inorganic filler in the insulating resin cured body is preferably 80 volume% or less and more preferably 75 volume% or less, and may be 70 volume% or less. That is, the content of the inorganic filler in the insulating resin cured body may be, for example, 30 to 80 volume%, 30 to 75 volume%, 30 to 70 volume%, 35 to 80 volume%, 35 to 75 volume%, 35 to 70 volume%, 40 to 80 volume%, 40 to 75 volume%, or 40 to 70 volume%.

The volume of the inorganic filler can be obtained by dividing the mass of the inorganic filler by a true specific gravity of the inorganic filler.

The insulating resin composition may further contain components other than those described above. The insulating resin composition may further contain, for example, a curing promoter, a discoloration inhibitor, a surfactant, a coupling agent, a colorant, a viscosity adjuster, an antioxidant, and an ion scavenger as necessary.

The content of other components is, based on the total amount of the insulating resin composition, 2 mass% or less, or may be 0 mass%.

(Insulating Resin Cured Body)

The insulating resin cured body of the present embodiment is a cured body of the above-described insulating resin composition. The insulating resin cured body can form an insulating layer having excellent insulation reliability, high heat cycle resistance, and high thermal conductivity under conditions of high temperature, high humidity, and high-voltage application.

The insulating resin cured body of the present embodiment may contain, for example, a cured body of the above-described resin component and an inorganic filler or a crushed material of the inorganic filler, and preferably contains a cured body of the above-described resin component and a crushed material of an inorganic filler.

The cross-linking density of the insulating resin cured body is preferably $1.0\times10^{-2}$ mol/cm$^3$ or more, and more preferably $4.0\times10^{-2}$ mol/cm$^3$ or more. Accordingly, the strength of the cured body is further improved, and the generation of cracks in a heat cycle test is further suppressed, so that an insulating layer with superior heat cycle resistance can be formed. In addition, the cross-linking density of the insulating resin cured body is preferably $8.0\times10^{-1}$ mol/cm$^3$ or less, and more preferably $5.0\times10^{-1}$ mol/cm$^3$ or less. Accordingly, the flexibility of the cured body is further improved, and an insulating layer having superior stress relaxation properties can be formed. That is, the cross-linking density of the insulating resin cured body may be, for example, $1.0\times10^{-2}$ to $8.0\times10^{-1}$ mol/cm$^3$, $1.0\times10^{-2}$ to $5.0\times10^{-1}$ mol/cm$^3$, $4.0\times10^{-2}$ to $8.0\times10^{-1}$ mol/cm$^3$, or $4.0\times10^{-2}$ to $5.0\times10^{-1}$ mol/cm$^3$. The cross-linking density can be appropriately adjusted by adjusting the ratio ($M_2/M_1$) of a total number $M_2$ of $-NHR^1$'s to a total number $M_1$ of $-NH^2$'s in the amine-based curing agent or adjusting the number of functional groups and the molecular weight of an epoxy resin.

In the present specification, the cross-linking density of the insulating resin cured body indicates a value

calculated through the following method.

<Method for Measuring Cross-Linking Density>

(1) Production of Measurement Sample

An insulating resin cured body is cut into a plate shape with a size of 1 mm × 3 mm × 40 mm with a diamond cutter to prepare a measurement sample.

(2) Measurement of Storage Modulus

The storage modulus of the measurement sample at a temperature $T_1$ (K) is measured through a DMA method (JIS K 0129 (2005)) using a dynamic viscoelasticity measuring device (manufactured by TA Instruments, "RSA 3"). The temperature $T_1$ is a glass transition point +30 (K) of a resin component constituting the insulating resin cured body. The measurement is performed in a temperature range of -50°C to +250°C under the conditions of a frequency of 10 Hz and a temperature rising rate of 10°C/min.

(3) Calculation of Cross-Linking Density

From the above-described measurement results, the cross-linking density (mol/cm$^3$) is calculated by the following equation. The gas constant is 8.31429 J/(mol·K).

Cross-linking density = Storage modulus / (3 × gas constant × $T_1$)

The storage modulus of the insulating resin cured body at -40°C is preferably 100 GPa or less and more preferably 50 GPa or less. Accordingly, the heat cycle characteristics tend to be further improved. The lower limit of the storage modulus of the insulating resin cured body at -40°C is not particularly limited.

In the present specification, the storage modulus of the insulating resin cured body indicates a value measured through the following method.

<Method for Measuring Storage Modulus>

(1) Production of Measurement Sample

An insulating resin cured body is cut into a plate shape with a size of 1 mm × 3 mm × 40 mm to prepare a measurement sample.

(2) Measurement of Storage Modulus

The storage modulus is measured with a dynamic viscoelasticity measuring device (manufactured by T&A Instruments, "RSA 3") in a temperature range of -50°C to +250°C under the conditions of a frequency of 10 Hz and a temperature rising rate of 10°C/min.

The method for producing an insulating resin cured body is not particularly limited. For example, the insulating resin cured body can be produced by curing an insulating resin composition through a heat treatment. The heat treatment may be performed in one step or in two steps. By performing the heat treatment in two steps, the insulating resin cured body can be formed through a semi-cured body of the insulating resin composition.

In a case where the heat treatment is performed in one step, the temperature for the heat treatment may be, for example, 40°C to 220°C and preferably 70°C to 180°C, and the time for the heat treatment may be, for example, 0.5 to 48 hours and preferably 1 to 6 hours.

In a case where the heat treatment is performed in two steps, the temperature for the heat treatment in the first step may be, for example, 40°C to 150°C and preferably 50°C to 100°C, and the time for the heat treatment may be, for example, 0.2 to 8 hours and preferably 0.5 to 5 hours. In addition, the temperature for the heat treatment in the second step may be, for example, 70°C to 220°C and preferably 120°C to 180°C, and the time for the heat treatment may be, for example, 0.5 to 9 hours and preferably 1 to 6 hours.

By performing the heat treatment while maintaining a predetermined shape of the insulating resin composition or the semi-cured body thereof, an insulating resin cured body with a predetermined shape can be obtained. For example, the insulating resin composition can be applied onto a metal plate, a metal foil can be stacked thereon as necessary, and curing

can be performed to form a layered insulating resin cured body on the metal plate.

The insulating resin cured body may be produced through a production method including a step of curing an insulating resin composition or a semi-cured body thereof through heat pressing. In particular, in a case where an inorganic filler contains agglomerated powders, such a production method is preferable because an insulating resin cured body containing a cured body of a resin component and a crushed material of the inorganic filler can be easily produced.

The conditions for heat pressing are not particularly limited. The pressing pressure may be, for example, 1 MPa or higher, preferably 5 MPa or higher, and more preferably 8 MPa or higher. Accordingly, formation of voids inside the cured body is suppressed, and the insulation properties tend to be further improved. In addition, the pressing pressure may be, for example, 30 MPa or lower, preferably 25 MPa or lower, and more preferably 20 MPa or lower. Accordingly, the excessive crushing of the agglomerated powders is suppressed, and the thermal conductivity tends to be further improved. The heating temperature may be the same as the above-described temperature for the heat treatment in the second step. That is, the pressing pressure may be, for example, 1 to 30 MPa, 1 to 25 MPa, 1 to 20 MPa, 5 to 30 MPa, 5 to 25 MPa, 5 to 20 MPa, 8 to 30 MPa, 8 to 25 MPa, or 8 to 20 MPa.

(Layered Body)

A layered body of the present embodiment includes: a metal plate; an insulating resin cured body placed on the metal plate; and a metal foil placed on the insulating resin cured body. In the layered body of the present embodiment, the metal plate and the metal foil may be separated from each other by the insulating resin cured body, or the insulating resin cured body may function as an insulating layer.

The metal material constituting the metal plate is not particularly limited, but examples thereof include aluminum, aluminum alloys, copper, copper alloys, iron alloys such iron and stainless steel. The metal plate may be made of one kind of metal material or may be made of two or more kinds of metal materials. In addition, the metal plate may be a single-layer structure or a multilayer structure.

The thickness of the metal plate is not particularly limited, but may be, for example, 0.5 to 3.0 mm from the viewpoint of being suitable for preparing a circuit substrate.

The metal material constituting the metal foil is not particularly limited, but examples thereof include copper, aluminum, and nickel. The metal foil may be made of one kind of metal material or may be made of two or more kinds of metal materials. In addition, the metal foil may be a single-layer structure or a multilayer structure.

The thickness of the metal foil is not particularly limited, but may be, for example, 0.009 to 1.0 mm from the viewpoint of being suitable for preparing a circuit substrate.

The thickness of the insulating resin cured body is not particularly limited, but may be, for example, 0.05 to 0.30 mm from the viewpoint of being suitable for preparing a circuit substrate.

In the layered body, the 90-degree peel strength of the metal foil at 85°C is preferably 2 N/cm or more and more preferably 4 N/cm or more. In such a layered body, sufficient adhesion between the metal foil and the insulating resin cured body is likely to be maintained even under conditions of high temperature, high humidity, and direct-current voltage application. Therefore, according to the layered body, a circuit substrate with superior heat cycle resistance can be obtained. The peel strength is measured through the above-described method.

The method for producing a layered body is not particularly limited. For example, a layered body can be produced through a method including a step of applying an insulating resin composition onto a metal plate to cure or semi-cure the insulating resin composition and a step of joining a metal foil onto the cured or semi-cured insulating resin composition (that is, an insulating resin cured body or a semi-cured body). The method may further include a step of curing a semi-cured body of an insulating resin composition (preferably a step of curing a semi-cured body of an insulating resin composition through heat pressing). The joining of a metal foil may be performed through a method, for example, a roll-lamination method or a lamination press method.

In addition, a layered body can also be produced through a method including a step of applying an insulating resin composition onto a metal foil to cure or semi-cure the insulating resin composition and a step of joining a metal plate onto the cured or semi-cured insulating resin composition (that is, an insulating resin cured body or a semi-cured body). The method may further include a step of curing a semi-cured body of an insulating resin composition (preferably a step of curing a semi-cured body of an insulating resin composition through heat pressing).

FIG. 1 is a cross-sectional view illustrating a suitable embodiment of a layered body. A layered body 10 includes a metal plate 1, a metal foil 3, and an insulating layer 2 which is interposed between the metal plate 1 and the metal foil 3 and composed of an insulating resin cured body. A circuit substrate can be easily formed by processing the metal foil 3 of the layered body 10 into a predetermined pattern.

(Circuit substrate)

A circuit substrate of the present embodiment includes: a metal plate; an insulating resin cured body placed on

the metal plate; and a circuit part placed on the insulating resin cured body. In the circuit substrate of the present embodiment, the metal plate and the circuit part may be separated from each other by the insulating resin cured body, or the insulating resin cured body may function as an insulating layer.

The same metal plates for the above-described layered body can be exemplified as the metal plate.

The circuit part may be made of a metal material. The same metal materials constituting the above-described metal foil can be exemplified as the metal material constituting the circuit part. The circuit part may be obtained by processing the above-described metal foil into a predetermined pattern.

The thickness of the circuit part is not particularly limited, but may be, for example, 0.035 to 0.5 mm from the viewpoints of the amount of current and heat dissipation properties.

The thickness of the insulating resin cured body is not particularly limited, but may be, for example, 0.07 to 0.2 mm from the viewpoints of the insulation properties and heat dissipation properties.

The method for manufacturing a circuit substrate is not particularly limited. For example, a circuit substrate can be manufactured through a method including a step of processing the metal foil of the above-described layered body into a predetermined pattern. The method for processing (etching) the metal foil is not particularly limited, and a well-known conventional method may be applied.

FIG. 2 is a cross-sectional view illustrating a suitable embodiment of a circuit substrate. A circuit substrate 20 shown in FIG. 2 includes a metal plate 1, a circuit part 4, and an insulating layer 2 which is interposed between the metal plate 1 and the circuit part 4 and composed of an insulating resin cured body. The circuit substrate 20 may be obtained by, for example, processing the metal foil 3 of the layered body 10 into the circuit part 4.

The suitable embodiments of the present invention have been described above, but the present invention is not limited to the above-described embodiments.

[Examples]

Hereinafter, the present invention will be described in detail with reference to examples. However, the present invention is not limited by these examples.

<Example 1>

(Amine-Based Curing Agent)

As an amine-based curing agent, an amine-based curing agent (1) containing 37 mass% of an amine compound represented by Formula (A-1-1) below, 17 mass% of an amine compound represented by Formula (A-1-2) below, 32 mass% of an amine compound represented by Formula (A-2-1), and 12 mass% of an amine compound represented by Formula (A-2-2) was prepared. These amine compounds can be synthesized through a well-known method.

[Chem. 7]

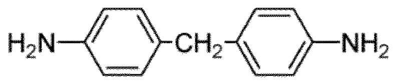

(A-1-1)

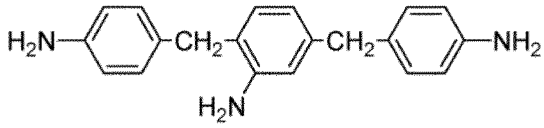

(A-1-2)

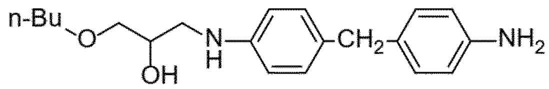

(A-2-1)

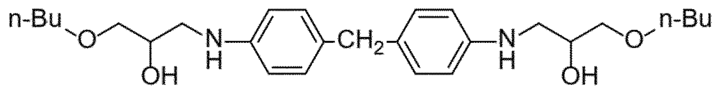

(A-2-2)

(Preparation of Insulating Resin Composition)

35.9 parts by volume of a bisphenol A-type epoxy resin (EXA850CRP, manufactured by Mitsubishi Chemical Corporation and represented as an "epoxy resin (1)" in tables) and 14.07 parts by volume of the above-described amine-based curing agent (1) were stirred and mixed with each other at 25°C. Subsequently, 50.0 parts by volume of an agglomerated boron nitride powder (manufactured by Denka Company Limited, had an average particle diameter of 60 μm, a crushing strength of 11 MPa, a tap density of 0.72 $g/cm^3$, a specific surface area of 4.5 $m^2/g$, and a thermal conductivity of 110 W/mK, and represented as an "inorganic filler (1)" in the tables) and 0.2 parts by volume of a curing promoter (2E4MZ, manufactured by Shikoku Chemicals Corporation, a specific gravity of 0.975 $g/cm^3$) were added thereto, and mixed therewith while stirring the mixture with a planetary mixer for 15 minutes to obtain an insulating resin composition.

(Manufacture of Circuit substrate)

An insulating resin composition was applied on a polyethylene terephthalate (PET) film with a thickness of 0.05 mm so that the thickness after curing was 0.20 mm, and the coating was heated at 100°C for 15 minutes to produce a sheet in a B-stage (semi-cured) state.

Subsequently, the produced sheet was peeled off from the PET film and placed on a copper plate with a thickness of 2.0 mm, and a copper foil (GTS-MP, manufactured by Furukawa Circuit Foil Co., Ltd.) with a thickness of 0.035 mm was placed thereon. Heat-curing was performed at 180°C for 180 minutes with a press while applying a surface pressure of 100 $kgf/cm^2$ to obtain a layered body.

Subsequently, after a predetermined position was masked with an etching resist, the copper foil was etched using a sulfuric acid-hydrogen peroxide mixed solution as an etchant. The etching resist was removed, and washing and drying were performed to obtain a circuit substrate having circular electrodes which were made of the copper foil and had a diameter of 20 mm.

<Example 2>

A circuit substrate was obtained in the same manner as in Example 1 except that a naphthalene-type epoxy resin (HP4032D, manufactured by DIC CORPORATION and represented as an "epoxy resin (2)" in the tables) was used instead of the bisphenol A-type epoxy resin and that the formulation amount of each component was changed as shown in Table 1.

<Example 3>

As an amine-based curing agent, an amine-based curing agent (2) containing 50 mass% of an amine compound represented by Formula (A-1-1) below, 18 mass% of an amine compound represented by Formula (A-1-2) below, and 30 mass% of an amine compound represented by Formula (A-2-2) was prepared.

A circuit substrate was obtained in the same manner as in Example 1 except that the amine-based curing agent (2) was used instead of the amine-based curing agent (1) and that the formulation amount of each component was changed as shown in Table 1.

<Examples 4 to 6>

A circuit substrate was obtained in the same manner as in Example 1 except that the formulation amount of each component was changed as shown in Table 1 or 2.

<Example 7>

A circuit substrate was obtained in the same manner as in Example 1 except that an agglomerated boron nitride powder (manufactured by Denka Company Limited, had an average particle diameter of 40 μm, a crushing strength of 11 MPa, a tap density of 0.77 g/cm$^3$, a specific surface area of 4.5 m$^2$/g, and a thermal conductivity of 110 W/mK, and represented as an "inorganic filler (2)" in the tables) was used instead of the inorganic filler (1) and that the formulation amount of each component was changed as shown in Table 2.

<Example 8>

A circuit substrate was obtained in the same manner as in Example 1 except that an agglomerated boron nitride powder (manufactured by Denka Company Limited, had an average particle diameter of 70 μm, a crushing strength of 2 MPa, a tap density of 0.52 g/cm$^3$, a specific surface area of 2.5 m$^2$/g, and a thermal conductivity of 110 W/mK, and represented as an "inorganic filler (3)" in the tables) was used instead of the inorganic filler (1) and that the formulation amount of each component was changed as shown in Table 2.

<Example 9>

A circuit substrate was obtained in the same manner as in Example 1 except that an agglomerated boron nitride powder (manufactured by Denka Company Limited, had an average particle diameter of 40 μm, a crushing strength of 7.9 MPa, a tap density of 0.77 g/cm$^3$, a specific surface area of 2.0 m$^2$/g, and a thermal conductivity of 110 W/mK, and represented as an "inorganic filler (4)" in the tables) was used instead of the inorganic filler (1) and that the formulation amount of each component was changed as shown in Table 2.

<Example 10>

A circuit substrate was obtained in the same manner as in Example 1 except that an aluminum nitride filler (manufactured by Denka Company Limited, had an average particle diameter of 32 μm and a thermal conductivity of 180 W/mK, and represented as an "inorganic filler (5)" in the tables) and an alumina filler AA2 (manufactured by Sumitomo Chemical Co., Ltd., had an average particle diameter of 2 μm and a thermal conductivity of 30 W/mK, and represented as an "inorganic filler (6)") were used instead of the inorganic filler (1) and that the formulation amount of each component was changed as shown in Table 2.

<Comparative Example 1>

A circuit substrate was obtained in the same manner as in Example 1 except that diaminodiphenyl sulfone (DDS) was used as a curing agent instead of the amine-based curing agent (1) and that the formulation amount of each component was changed as shown in Table 3.

<Comparative Example 2>

A circuit substrate was obtained in the same manner as in Example 1 except that methylenedianiline (diaminodiphenylmethane, DDM) was used as a curing agent instead of the amine-based curing agent (1) and that the formulation amount of each component was changed as shown in Table 3.

<Comparative Example 3>

A circuit substrate was obtained in the same manner as in Example 1 except that a novolac-type phenol resin (VH-4150, manufactured by DIC CORPORATION) was used as a curing agent instead of the amine-based curing agent

(1) and that the formulation amount of each component was changed as shown in Table 3.

<Comparative Example 4>

A circuit substrate was obtained in the same manner as in Example 1 except that a silica filler A-1 (manufactured by Tatsumori Ltd., had an average particle diameter of 12 μm and a thermal conductivity of 2 W/mK, and represented as an "inorganic filler (7)" in the tables) was used instead of the inorganic filler (1) and that the formulation amount of each component was changed as shown in Table 3.

<Comparative Example 5>

A circuit substrate was obtained in the same manner as in Example 1 except that the formulation amount of each component was changed as shown in Table 3.

The examples and the comparative examples were evaluated by the following method. The results are shown in Tables 1 to 3.

[Evaluation of Thermal Conductivity]

Sheets in a B-stage (semi-cured) state obtained through the above-described method were stacked and subjected to heat press molding to produce a thermoconductive sheet with a length of 10 mm, a width of 10 mm, and a thickness of 0.5 mm, and the thermal diffusivity $\alpha$ was measured through a laser flash method to obtain a thermal conductivity $\lambda$ from the following equation. The thermal conductivity is preferably 8 W/mK or more.

$$\lambda=\alpha\times Cp\times\rho$$

The specific heat Cp was calculated from DSC measurement.

In addition, the specific gravity $\rho$ of the thermoconductive sheet was calculated by the following equation by measuring the weight of the sheet at a temperature of 25°C and an atmospheric pressure of 1013 hPa in air and the weight thereof in distilled water using a specific gravity measurement kit AD-1653 (trade name) of A&D Company, Limited.

$$\rho=A/(A-B)\times(\rho0-d)+d$$

(In the equation, A represents the mass of the thermoconductive sheet in air, B represents the mass of the thermoconductive sheet in distilled water, $\rho0$ represents the density of the distilled water, and d represents the density of air.

[Evaluation of Insulation Properties]

The dielectric strength of each circuit substrate obtained through the above-described method was measured using TOS 8650 (trade name) manufactured by Kikusui Electronics Corp. based on JIS C 6481. When the thermoconductive sheet has a thickness of 0.20 mm, the dielectric strength is preferably 8 kV or more (40 kV/mm or more).

[Storage Modulus and Cross-Linking Density of Insulating Resin Cured Body]

After the insulating resin composition was defoamed in a vacuum, it was cured under the curing conditions of 50°C for 3 hours and 160°C for 6 hours to obtain an insulating resin cured body. The obtained insulating resin cured body was cut with diamond cutter to obtain a plate-like measurement sample of 1 mm × 3 mm × 40 mm. The storage modulus of this measurement sample at a temperature $T_1$ (K) was measured through a DMA method (JIS K 0129 (2005)) using a dynamic viscoelasticity measuring device (manufactured by TA Instruments, "RSA 3"). The temperature $T_1$ was regarded as a glass transition point +30 (K) of a resin component constituting the insulating resin cured body, and the storage modulus was measured in a temperature range of -50°C to +250°C under the conditions of a frequency of 10 Hz and a temperature rising rate of 10°C/min. From the above-described measurement results, the cross-linking density (mol/cm$^3$) was calculated by the following equation.

Cross-linking density = Storage modulus / (3 × gas constant × $T_1$)

[Evaluation of Reliability by High-Temperature High humidity Bias (THB) Test]

A high-temperature high-humidity bias (THB) test was performed under the test condition of applying a DC voltage of 1200 V between a metal foil and a metal plate in an environment of a temperature of 85°C and a humidity of 85%. A case where the endurance time was 350 hours or longer was evaluated as A, and a case where the endurance time was shorter than 200 hours was evaluated as C.

[Evaluation of Heat Cycle Resistance]

6 chip resistors with a chip size of 2.0 mm × 1.25 mm were mounted on each circuit substrate with lead-tin eutectic solder, and a heat cycle test was performed 500 times with -40°C for 7 minutes and +125°C for 7 minutes as one cycle. After the test was carried out, the cross section of a connection portion between the solder and the components was observed with a 50× microscope to check generation of cracks. The same test was carried out three times, and the number of cracks generated in 18 connection portions (6 connection portions × 3 times) was obtained and evaluated.

[Table 1]

| | | Unit | Example 1 | Example 2 | Example 3 | Example 4 | Example 5 |
|---|---|---|---|---|---|---|---|
| Epoxy resin | Epoxy resin (1) | Parts by volume | 35.9 | - | 35.9 | 41.8 | 49.2 |
| | Epoxy resin (2) | Parts by volume | - | 33.18 | - | - | - |
| Curing agent | Amine-based curing agent (1) | Parts by volume | 14.07 | 16.81 | - | 8.2 | 19.3 |
| | Amine-based curing agent (2) | Parts by volume | - | - | 14.1 | - | - |
| | DDS | Parts by volume | - | - | - | - | - |
| | DDM | Parts by volume | - | - | - | - | - |
| | VH-4150 | Parts by volume | - | - | - | - | - |
| Curing promoter | 2E4MZ | Parts by volume | 0.2 | 0.1 | 0.2 | 0.4 | 0.2 |
| Inorganic filler | Inorganic filler (1) | Parts by volume | 50 | 50 | 50 | 50 | 35 |
| | Inorganic filler (2) | Parts by volume | - | - | - | - | - |
| | Inorganic filler (3) | Parts by volume | - | - | - | - | - |
| | Inorganic filler (4) | Parts by volume | - | - | - | - | - |
| | Inorganic filler (5) | Parts by volume | - | - | - | - | - |
| | Inorganic filler (6) | Parts by volume | - | - | - | - | - |
| | Inorganic filler (7) | Parts by volume | - | - | - | - | - |

(continued)

| | | Unit | Example 1 | Example 2 | Example 3 | Example 4 | Example 5 |
|---|---|---|---|---|---|---|---|
| Evaluation results | Thermal conductivity | W/mK | 10.8 | 10.4 | 10.5 | 11 | 8.1 |
| | Insulation properties | kV/mm | ≥50 | ≥50 | 48 | 47 | ≥50 |
| | Storage modulus at -40°C | Pa | $9.00\times10^{9}$ | $1.30\times10^{10}$ | $1.00\times10^{10}$ | $1.50\times10^{10}$ | $8.90\times10^{9}$ |
| | Storage modulus at temperature T1 | Pa | $2.27\times10^{9}$ | $2.50\times10^{9}$ | $2.46\times10^{9}$ | $2.62\times10^{9}$ | $0.76\times10^{9}$ |
| | Cross-linking density | $mol/cm^3$ | $1.90\times10^{-1}$ | $2.05\times10^{-1}$ | $2.06\times10^{-1}$ | $2.15\times10^{-1}$ | $6.38\times10^{-2}$ |
| | THB test | - | A | A | A | A | A |
| | Heat cycle resistance | Number of cracks | 0/18 | 0/18 | 0/18 | 0/18 | 0/18 |

[Table 2]

| | | Unit | Example 6 | Example 7 | Example 8 | Example 9 | Example 10 |
|---|---|---|---|---|---|---|---|
| Epoxy resin | Epoxy resin (1) | Parts by volume | 28.8 | 35.9 | 35.9 | 35.9 | 18.7 |
| | Epoxy resin (2) | Parts by volume | - | - | - | - | - |
| Curing agent | Amine-based curing agent (1) | Parts by volume | 11.3 | 14.1 | 14.07 | 14.07 | 7.3 |
| | Amine-based curing agent (2) | Parts by volume | - | - | - | - | - |
| | DDS | Parts by volume | - | - | - | - | - |
| | DDM | Parts by volume | - | - | - | - | - |
| | VH-4150 | Parts by volume | - | - | - | - | - |
| Curing promoter | 2E4MZ | Parts by volume | 0.2 | 0.2 | 0.2 | 0.2 | 0.2 |

(continued)

| | | Unit | Example 6 | Example 7 | Example 8 | Example 9 | Example 10 |
|---|---|---|---|---|---|---|---|
| Inorganic filler | Inorganic filler (1) | Parts by volume | 60 | - | - | - | - |
| | Inorganic filler (2) | Parts by volume | - | 50 | - | - | - |
| | Inorganic filler (3) | Parts by volume | - | - | 50 | - | - |
| | Inorganic filler (4) | Parts by volume | - | - | - | 50 | - |
| | Inorganic filler (5) | Parts by volume | - | - | - | - | 26.3 |
| | Inorganic filler (6) | Parts by volume | - | - | - | - | 47.7 |
| | Inorganic filler (7) | Parts by volume | - | - | - | - | - |
| Evaluation results | Thermal conductivity | W/mK | 13.2 | 9.1 | 9.5 | 9 | 8 |
| | Insulation properties | kV/mm | 40 | ≥50 | 42 | ≥50 | 41 |
| | Storage modulus at -40°C | Pa | $9.40\times10^{9}$ | $1.00\times10^{10}$ | $9.00\times10^{9}$ | $9.00\times10^{9}$ | $9.00\times10^{9}$ |
| | Storage modulus at temperature T1 | Pa | $2.71\times10^{9}$ | $2.13\times10^{9}$ | $2.30\times10^{9}$ | $1.89\times10^{9}$ | $3.15\times10^{9}$ |
| | Cross-linking density | $mol/cm^3$ | $2.27\times10^{-1}$ | $1.79\times10^{-1}$ | $1.93\times10^{-1}$ | $1.59\times10^{-1}$ | $2.64\times10^{-1}$ |
| | THB test | - | A | A | A | A | A |
| | Heat cycle resistance | Number of cracks | 0/18 | 0/18 | 0/18 | 0/18 | 0/18 |

[Table 3]

| | | Unit | Comparative Example 1 | Comparative Example 2 | Comparative Example 3 | Comparative Example 4 | Comparative Example 5 |
|---|---|---|---|---|---|---|---|
| Epoxy resin | Epoxy resin (1) | Parts by volume | 35.9 | 38.6 | 29.5 | 35.9 | 57.5 |
| | Epoxy resin (2) | Parts by volume | - | - | - | - | - |
| Curing agent | Amine-based curing agent (1) | Parts by volume | - | - | - | 14.07 | 22.50 |
| | Amine-based curing agent (2) | Parts by volume | - | - | - | - | - |
| | DDS | Parts by volume | 14.1 | - | - | - | - |
| | DDM | Parts by volume | - | 11.4 | - | - | - |
| | VH-4150 | Parts by volume | - | - | 20.5 | - | - |
| Curing promoter | 2E4MZ | Parts by volume | 0.2 | 0.2 | 0.3 | 0.2 | 0.5 |
| Inorganic filler | Inorganic filler (1) | Parts by volume | 50 | 50 | 50 | - | 20 |
| | Inorganic filler (2) | Parts by volume | - | - | - | - | - |
| | Inorganic filler (3) | Parts by volume | - | - | - | - | - |
| | Inorganic filler (4) | Parts by volume | - | - | - | - | - |
| | Inorganic filler (5) | Parts by volume | - | - | - | - | - |
| | Inorganic filler (6) | Parts by volume | - | - | - | - | - |
| | Inorganic filler (7) | Parts by volume | - | - | - | 50 | - |
| Evaluation results | Thermal conductivity | W/mK | 10.1 | 10.1 | 8.2 | 1 | 3.0 |
| | Insulation properties | kV/mm | 48 | ≥ 50 | ≥ 50 | ≥ 50 | ≥ 50 |
| | Storage modulus at -40°C | Pa | $9.50\times10^{9}$ | $1.10\times10^{10}$ | $1.00\times10^{10}$ | $9.00\times10^{9}$ | $5.00\times10^{9}$ |
| | Storage modulus at temperature T1 | Pa | $2.52\times10^{9}$ | $2.58\times10^{9}$ | $2.66\times10^{9}$ | $2.12\times10^{9}$ | $0.45\times10^{9}$ |
| | Cross-linking density | $mol/cm^3$ | $211\times10^{-1}$ | $2.16\times10^{-1}$ | $2.19\times10^{-1}$ | $1.78\times10^{-1}$ | $2.64\times10^{-2}$ |
| | THB test | - | C | C | C | A | A |
| | Heat cycle resistance | Number of cracks | 1/18 | 0/18 | 1/18 | 0/18 | 0/18 |

## Reference Signs List

1 Metal plate
2 Insulating layer
3 Metal foil
4 Circuit part
10 Layered body
20 Circuit substrate

## Claims

**1.** An insulating resin composition comprising:

an epoxy resin;
an amine-based curing agent containing a first amine compound represented by Formula (A-1) and a second amine compound represented by Formula (A-2), wherein, in the amine-based curing agent, a ratio ($M_2/M_1$) of a total number $M_2$ of -NHR$^1$'s to a total number $M^1$ of -NH$^2$'s is 0.05 to 0.30; and
an inorganic filler having a thermal conductivity of 20 W/mK or higher,
wherein a content of the inorganic filler is 30 to 80 volume%,
wherein the content of components other than the epoxy resin, the amine-based curing agent and the inorganic filler is 2 mass% or less based on the total amount of the insulating resin composition,

[Chem. 1]

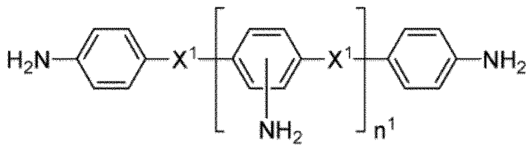

(A-1)

[in Formula (A-1), $n^1$ represents an integer of 0 to 4, and $X^1$ represents an alkanediyl group, an oxygen atom, or a sulfur atom; and
when $n^1$ is 1 or more, plural $X^1$'s may be the same as or different from each other,]

[Chem. 2]

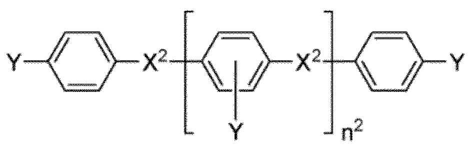

(A-2)

[in Formula (A-2), $n^2$ represents an integer of 0 to 4, $X^2$ represents an alkanediyl group, an oxygen atom, or a sulfur atom, and Y represents a group represented by -NH$^2$ or -NHR$^1$ ($R^1$ represents a group represented by Formula (Y-1)); plural Y's may be the same as or different from each other, provided that at least one of Y's is -NHR$^1$; and when $n^2$ is 1 or more, plural $X^2$'s may be the same as or different from each other, and]

[Chem. 3]

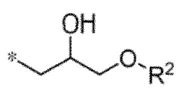

(Y-1)

[in Formula (Y-1), $R^2$ represents an alkyl group].

2. The insulating resin composition according to claim 1, wherein the inorganic filler contains an agglomerated powder containing an aggregate of primary particles.

3. The insulating resin composition according to claim 2, wherein the agglomerated powder has an average particle diameter of 20 to 100 μm, wherein the average particle diameter is determined according to the method described in the specification.

4. The insulating resin composition according to claim 2 or 3, wherein the agglomerated powder has a crushing strength of 1 to 30 MPa, wherein the crushing strength is determined according to the method described in the specification.

5. The insulating resin composition according to any one of claims 2 to 4, Wherein the agglomerated powder has a tap density of 0.7 to 2.0 g/$cm^3$, wherein the tap density is determined according to the method described in the specification.

6. The insulating resin composition according to any one of claims 2 to 5, wherein the agglomerated powder has a specific surface area of 3.0 to 10.0 $m^2$/g, wherein the specific surface area is determined using the method described in the specification.

7. The insulating resin composition according to any one of claims 2 to 6, wherein the agglomerated powder contains boron nitride.

8. The insulating resin composition according to any one of claims 1 to 7, wherein the $X^1$ and the $X^2$ are methanediyl groups.

9. The insulating resin composition according to any one of claims 1 to 8, wherein, in the amine-based curing agent, a content of the first amine compound is 30 to 60 mass% and a content of the second amine compound is 40 to 70 mass%.

10. The insulating resin composition according to any one of claims 1 to 9, wherein a ratio of an active hydrogen equivalent of the amine-based curing agent to an epoxy equivalent of the epoxy resin is 0.3 to 1.5.

11. An insulating resin cured body which is a cured body of the insulating resin composition according to any one of claims 1 to 10.

12. The insulating resin cured body according to claim 11, comprising: a crushed material of the inorganic filler.

13. The insulating resin cured body according to claim 11 or 12, wherein a cross-linking density is $4.0\times10^{-2}$ $5.0\times10^{-1}$ mol/$cm^3$, wherein the cross-linking density is calculated using the method set out in the description.

14. The insulating resin cured body according to any one of claims 11 to 13, wherein a storage elastic modulus at -40°C is 100 GPa or less, wherein the storage elastic modulus is determined according to the method described in the specification.

15. A method for producing an insulating resin cured body, the method comprising: a step of curing the insulating resin composition according to any one of claims 1 to 10 or a semi-cured body thereof through heat pressing to produce an insulating resin cured body.

16. A layered body comprising:

    a metal plate;
    the insulating resin cured body according to any one of claims 11 to 14 placed on the metal plate; and
    a metal foil placed on the insulating resin cured body.

17. A circuit substrate comprising:

a metal plate;
the insulating resin cured body according to any one of claims 11 to 14 placed on the metal plate; and
a circuit part placed on the insulating resin cured body.

## Patentansprüche

1. Isolierende Harzzusammensetzung, umfassend:

ein Epoxidharz,
ein Härtungsmittel auf Aminbasis, das eine durch Formel (A-1) dargestellte erste Aminverbindung und eine durch Formel (A-2) dargestellte zweite Aminverbindung enthält, wobei in dem Härtungsmittel auf Aminbasis ein Verhältnis ($M_2/M_1$) einer Gesamtanzahl $M_2$ von $-NHR^1$ zu einer Gesamtanzahl $M^1$ von $-NH^2$ 0,05 bis 0,30 beträgt, und
einen anorganischen Füllstoff mit einer Wärmeleitfähigkeit von 20 W/mK oder höher,
wobei ein Gehalt des anorganischen Füllstoffs 30 bis 80 Volumen-% beträgt,
wobei der Gehalt von anderen Komponenten als dem Epoxidharz, dem Härtungsmittel auf Aminbasis und dem anorganischen Füllstoff 2 Masse-% oder weniger, bezogen auf die Gesamtmenge der isolierenden Harzzusammensetzung, beträgt,

[Chem. 1]

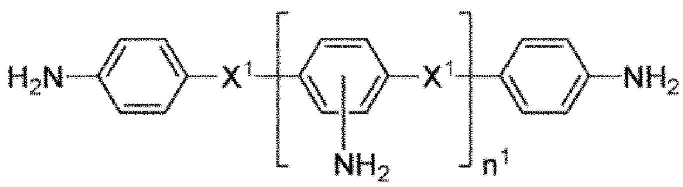

(A-1)

[in Formel (A-1) stellt $n^1$ eine ganze Zahl von 0 bis 4 dar und $X^1$ stellt eine Alkandiylgruppe, ein Sauerstoffatom oder ein Schwefelatom dar, und wenn $n^1$ 1 oder größer ist, können mehrere $X^1$ gleich oder verschieden voneinander sein,]

[Chem. 2]

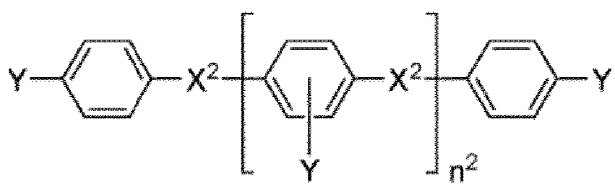

(A-2)

[in Formel (A-2) stellt $n^2$ eine ganze Zahl von 0 bis 4 dar, $X^2$ stellt eine Alkandiylgruppe, ein Sauerstoffatom oder ein Schwefelatom dar und Y stellt eine durch $-NH^2$ oder $-NHR^1$ dargestellte Gruppe dar ($R^1$ stellt eine durch Formel (Y-1) dargestellte Gruppe dar), mehrere Y können gleich oder verschieden voneinander sein, vorausgesetzt, dass mindestens eines der Y $-NHR^1$ ist, und wenn $n^2$ 1 oder größer ist, können mehrere $X^2$ gleich oder verschieden voneinander sein, und]

[Chem. 3]

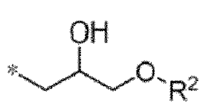

(Y-1)

[in Formel (Y-1) stellt $R^2$ eine Alkylgruppe dar].

**2.** Isolierende Harzzusammensetzung gemäß Anspruch 1, wobei der anorganische Füllstoff ein agglomeriertes Pulver enthält, das ein Aggregat aus Primärpartikeln enthält.

**3.** Isolierende Harzzusammensetzung gemäß Anspruch 2, wobei das agglomerierte Pulver einen durchschnittlichen Partikeldurchmesser von 20 bis 100 μm aufweist, wobei der durchschnittliche Partikeldurchmesser gemäß dem in der Beschreibung beschriebenen Verfahren bestimmt wird.

**4.** Isolierende Harzzusammensetzung gemäß Anspruch 2 oder 3, wobei das agglomerierte Pulver eine Druckfestigkeit von 1 bis 30 MPa aufweist, wobei die Druckfestigkeit gemäß dem in der Beschreibung beschriebenen Verfahren bestimmt wird.

**5.** Isolierende Harzzusammensetzung gemäß einem der Ansprüche 2 bis 4, wobei das agglomerierte Pulver eine Klopfdichte von 0,7 bis 2,0 $g/cm^3$ aufweist, wobei die Klopfdichte gemäß dem in der Beschreibung beschriebenen Verfahren bestimmt wird.

**6.** Isolierende Harzzusammensetzung gemäß einem der Ansprüche 2 bis 5, wobei das agglomerierte Pulver eine spezifische Oberfläche von 3,0 bis 10,0 $m^2/g$ aufweist, wobei die spezifische Oberfläche unter Verwendung des in der Beschreibung beschriebenen Verfahrens bestimmt wird.

**7.** Isolierende Harzzusammensetzung gemäß einem der Ansprüche 2 bis 6, wobei das agglomerierte Pulver Bornitrid enthält.

**8.** Isolierende Harzzusammensetzung gemäß einem der Ansprüche 1 bis 7, wobei das $X^1$ und $X^2$ Methandiylgruppen sind.

**9.** Isolierende Harzzusammensetzung gemäß einem der Ansprüche 1 bis 8, wobei in dem Härtungsmittel auf Aminbasis ein Gehalt der ersten Aminverbindung 30 bis 60 Masse-% beträgt und ein Gehalt der zweiten Aminverbindung 40 bis 70 Masse-% beträgt.

**10.** Isolierende Harzzusammensetzung gemäß einem der Ansprüche 1 bis 9, wobei ein Verhältnis eines aktiven Wasserstoffäquivalents des Härtungsmittels auf Aminbasis zu einem Epoxidäquivalent des Epoxidharzes 0,3 bis 1,5 beträgt.

**11.** Gehärteter Körper aus isolierendem Harz, der ein gehärteter Körper aus der isolierenden Harzzusammensetzung gemäß einem der Ansprüche 1 bis 10 ist.

**12.** Gehärteter Körper aus isolierendem Harz gemäß Anspruch 11, umfassend: ein zerkleinertes Material aus dem anorganischen Füllstoff.

**13.** Gehärteter Körper aus isolierendem Harz gemäß Anspruch 11 oder 12, wobei eine Vernetzungsdichte $4{,}0\times10^{-2}$ $5{,}0\times10^{-1}$ $mol/cm^3$ beträgt, wobei die Vernetzungsdichte unter Verwendung des in der Beschreibung dargelegten Verfahrens berechnet wird.

**14.** Gehärteter Körper aus isolierendem Harz gemäß einem der Ansprüche 11 bis 13, wobei ein Speicherelastizitätsmodul bei -40°C 100 GPa oder weniger beträgt, wobei der Speicherelastizitätsmodul gemäß dem in der Beschreibung beschriebenen Verfahren bestimmt wird.

**15.** Verfahren zur Herstellung eines gehärteten Körpers aus isolierendem Harz, wobei das Verfahren umfasst: einen Schritt zum Härten der isolierenden Harzzusammensetzung gemäß einem der Ansprüche 1 bis 10 oder eines halbgehärteten Körpers davon durch Heißpressen, um einen gehärteten Körper aus isolierendem Harz herzustellen.

**16.** Schichtkörper, umfassend:

eine Metallplatte,
den gehärteten Körper aus isolierendem Harz gemäß einem der Ansprüche 11 bis 14, der auf der Metallplatte platziert ist, und
eine Metallfolie, die auf dem gehärteten Körper aus isolierendem Harz platziert ist.

**17.** Schaltungssubstrat, umfassend:

eine Metallplatte,
den gehärteten Körper aus isolierendem Harz gemäß einem der Ansprüche 11 bis 14, der auf der Metallplatte platziert ist, und
einen Schaltungsteil, der auf dem gehärteten Körper aus isolierendem Harz platziert ist.

**Revendications**

**1.** Composition de résine isolante comprenant :

une résine époxy ;
un agent de durcissement à base d'amine contenant un premier composé amine représenté par la Formule (A-1) et un second composé amine représenté par la Formule (A-2), dans lequel, dans l'agent de durcissement à base d'amine, un rapport ($M_2/M_1$) d'un nombre total $M_2$ des -$NHR^1$ sur un nombre total $M^1$ des -$NH^2$ est de 0,05 à 0,30 ; et
une charge inorganique présentant une conductivité thermique de 20 W/mK ou plus,
dans laquelle une teneur en la charge inorganique est de 30 à 80 % en volume,
dans laquelle la teneur en composants autres que la résine époxy, l'agent de durcissement à base d'amine et la charge inorganique est de 2 % en masse ou moins sur la base de la quantité totale de la composition de résine isolante,

[Chim. 1]

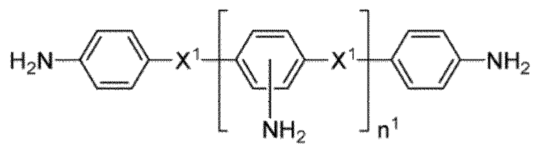

(A-1)

[dans la Formule (A-1), $n^1$ représente un nombre entier de 0 à 4, et $X^1$ représente un groupe alcanediyle, un atome d'oxygène, ou un atome de soufre ; et lorsque $n^1$ vaut 1 ou plus, plusieurs $X^1$ peuvent être identiques les uns aux autres ou différents les uns des autres,]

[Chim. 2]

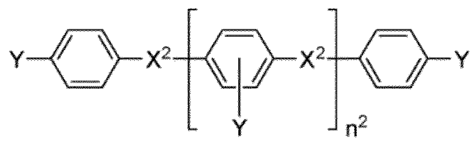

(A-2)

[dans la Formule (A-2), $n^2$ représente un nombre entier de 0 à 4, $X^2$ représente un groupe alcanediyle, un atome d'oxygène, ou un atome de soufre, et Y représente un groupe représenté par -$NH_2$ ou -$NHR^1$ ($R^1$ représente un groupe représenté par la Formule (Y-1)) ; plusieurs Y peuvent être identiques les uns aux autres ou différents les uns des autres, à condition qu'au moins un des Y soit -$NHR^1$ ; et lorsque $n^2$ vaut 1 ou plus, plusieurs $X^2$ peuvent être identiques les uns aux autres ou différents les uns des autres, et

[Chim. 3]

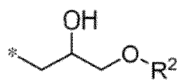

(Y-1)

[dans la Formule (Y-1), $R^2$ représente un groupe alkyle].

**2.** Composition de résine isolante selon la revendication 1,
dans laquelle la charge inorganique contient une poudre agglomérée contenant un agrégat de particules primaires.

3. Composition de résine isolante selon la revendication 2,
dans laquelle la poudre agglomérée présente un diamètre de particule moyen de 20 à 100 μm, dans laquelle le diamètre de particule moyen est déterminé selon le procédé décrit dans la spécification.

4. Composition de résine isolante selon la revendication 2 ou la revendication 3,
dans laquelle la poudre agglomérée présente une résistance à l'écrasement de 1 à 30 MPa, dans laquelle la résistance à l'écrasement est déterminée selon le procédé décrit dans la spécification.

5. Composition de résine isolante selon l'une quelconque des revendications 2 à 4,
dans laquelle la poudre agglomérée présente une densité après tassement de 0,7 à 2,0 g/$cm^3$, dans laquelle la densité après tassement est déterminée selon le procédé décrit dans la spécification.

6. Composition de résine isolante selon l'une quelconque des revendications 2 à 5,
dans laquelle la poudre agglomérée présente une superficie spécifique de 3,0 à 10,0 $m^2$/g, dans laquelle la superficie spécifique est déterminée en utilisant le procédé décrit dans la spécification.

7. Composition de résine isolante selon l'une quelconque des revendications 2 à 6,
dans laquelle la poudre agglomérée contient du nitrure de bore.

8. Composition de résine isolante selon l'une quelconque des revendications 1 à 7,
dans laquelle le $X^1$ et le $X^2$ sont des groupes méthanediyle.

9. Composition de résine isolante selon l'une quelconque des revendications 1 à 8,
dans laquelle, dans l'agent de durcissement à base d'amine, une teneur en premier composé amine est de 30 à 60 % en masse et une teneur en second composé amine est de 40 à 70 % en masse.

10. Composition de résine isolante selon l'une quelconque des revendications 1 à 9,
dans laquelle un rapport d'un équivalent d'hydrogène actif de l'agent de durcissement à base d'amine sur un équivalent d'époxy de la résine époxy est de 0,3 à 1,5.

11. Corps durci de résine isolante qui est un corps durci de la composition de résine isolante selon l'une quelconque des revendications 1 à 10.

12. Corps durci de résine isolante selon la revendication 11, comprenant :
un matériau écrasé de la charge inorganique.

13. Corps durci de résine isolante selon la revendication 11 ou la revendication 12,
dans lequel une densité de réticulation est de $4{,}0\times10^{-2}$ $5{,}0\times10^{-1}$ mol/$cm^3$, dans lequel la densité de réticulation est calculée en utilisant le procédé exposé dans la description.

14. Corps durci de résine isolante selon l'une quelconque des revendications 11 à 13,
dans lequel un module élastique de stockage à -40 °C est de 100 GPa ou moins, dans lequel le module élastique de stockage est déterminé selon le procédé décrit dans la spécification.

15. Procédé de production d'un corps durci de résine isolante, le procédé comprenant :
une étape consistant à faire durcir la composition de résine isolante selon l'une quelconque des revendications 1 à 10 ou un corps semi-durci de celle-ci par le biais d'un pressage à chaud afin de produire un corps durci en résine isolante.

16. Corps stratifié comprenant :

une plaque métallique ;
le corps durci de résine isolante selon l'une quelconque des revendications 11 à 14 placé sur la plaque métallique ; et
une feuille métallique placée sur le corps durci en résine isolante.

17. Substrat de circuit comprenant :

une plaque métallique ;

le corps durci de résine isolante selon l'une quelconque des revendications 11 à 14 placé sur la plaque métallique ; et
une partie de circuit placée sur le corps durci de résine isolante.

Fig.1

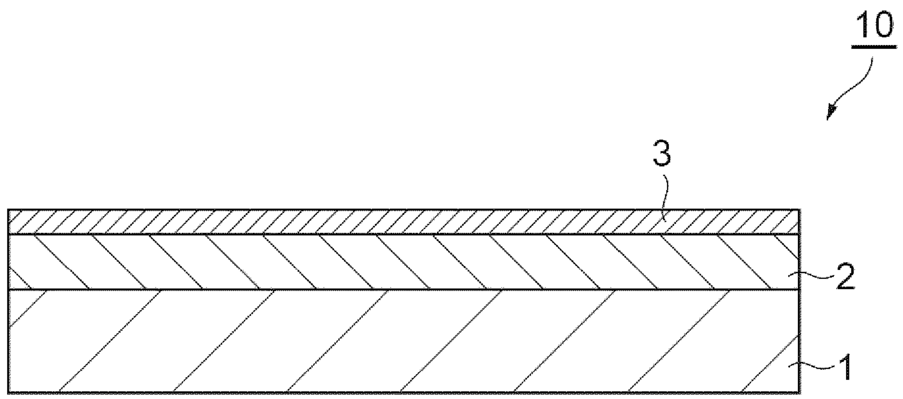

*Fig.2*

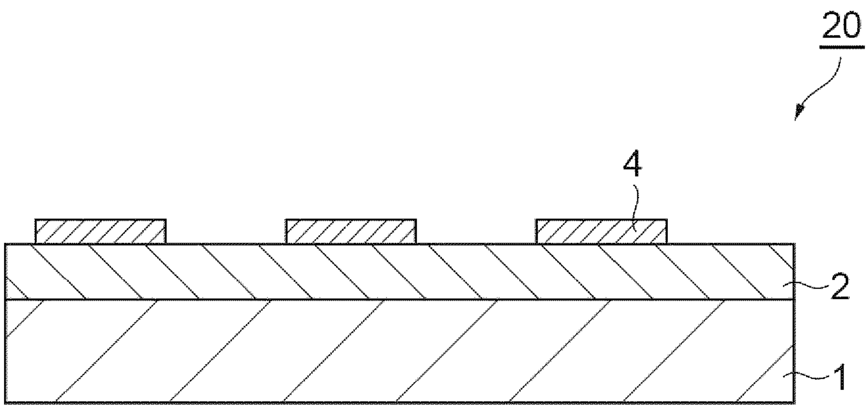

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP S58103526 A
- JP 2008266533 A


### Non-patent literature cited in the description


- *Journal of the Mining and Metallurgical Institute of Japan*, 1965, vol. 81, 1024